# EUROPÄISCHE PATENTSCHRIFT

(11) **EP 2 880 723 B1**
(45) Veröffentlichungstag und Bekanntmachung des Hinweises auf die Patenterteilung: **03.05.2017**
(21) Anmeldenummer: 13756283.1
(22) Anmeldetag: 26.07.2013
(51) Int. Cl.: H01S 3/0941, H01S 5/40, H01S 3/06, G02B 19/00, G02B 27/09

(54) **PUMPEINRICHTUNG ZUM PUMPEN EINES VERSTARKENDEN LASERMEDIUMS**
PUMPING DEVICE FOR PUMPING AN AMPLIFYING LASER MEDIUM
DISPOSITIF DE POMPAGE POUR POMPER UN MILIEU AMPLIFICATEUR LASER

(30) Priorität: 03.08.2012 AT 8582012
(43) Veröffentlichungstag der Anmeldung: 10.06.2015
(73) Patentinhaber: Kopf, Daniel, 6832 Röthis (AT)
(72) Erfinder: Kopf, Daniel, 6832 Röthis (AT)
(74) Vertreter: Hofmann, Ralf U.
(86) Internationale Anmeldenummer: PCT/AT2013/000126
(87) Internationale Veröffentlichungsnummer: WO 2014/019003

(56) Entgegenhaltungen:
- EP-A1- 0 717 476
- EP-A1- 1 391 753
- EP-A1- 2 061 122
- WO-A1-2010/017619
- JP-A- 2004 096 092
- US-A- 5 900 981
- US-A1- 2002 025 096
- US-A1- 2007 064 754
- US-A1- 2011 064 112
- XIUHUA MA ET AL: "Conductively cooled all-solid-state zigzag slab laser", CHINESE OPTICS LETTERS, vol. 6, no. 5, 1 January 2008 (2008-01-01) , pages 366-368, XP055314418, CN ISSN: 1671-7694, DOI: 10.3788/COL20080605.0366

## Beschreibung

Die Erfindung bezieht sich auf einen seitengepumpten Festkörperlaser mit einer Pumpeinrichtung zum Pumpen eines verstärkenden Lasermediums, umfassend eine Strahlungsquelle mit einer Mehrzahl von Laserdioden, die Laserstrahlen emittieren, welche parallele, in Richtung einer z-Achse verlaufende Strahlachsen aufweisen und in Richtung einer rechtwinkelig zur z-Achse stehenden x-Achse mindestens doppelt so stark divergieren wie in Richtung einer rechtwinkelig zur z-Achse und rechtwinkelig zur x-Achse stehenden y-Achse, und mindestens ein optisches Bauteil mit zumindest einer Zylinderfläche, mit der zumindest ein Teil der von den Laserdioden emittierten Laserstrahlen zusammenwirkt.

Zum Pumpen von Festkörperlasern werden in jüngerer Zeit anstelle der herkömmlichen Blitzlampen vermehrt Laserdioden eingesetzt. Ein in dieser Weise gepumpter Festkörperlaser ist beispielsweise in Errico Armandillo and Callum Norrie: "Diode-pumped high-efficiency high-brightness Q-switched ND:YAG slab laser", OPTICS LETTERS, Vol. 22, No. 15, 1. August 1997, Seiten 1168 bis 1170 beschrieben. Laserdioden haben insbesondere Vorteile hinsichtlich des Wirkungsgrades, der Pumpeffizienz und der Lebensdauer. Um höhere Pumpleistungen zu erreichen, werden mehrere Laserdioden in einem gemeinsamen Bauteil zusammengefasst. Bei Barren (englisch "bar") werden auf einem streifenförmigen Chip mehrere Laserdioden (=Einzelemitter) angeordnet und elektrisch parallel betrieben sowie auf einer gemeinsamen Wärmesenke montiert. Die Einzelemitter eines solchen Barrens emittieren jeweils einen Laserstrahl, der in Richtung einer sogenannten "fast-axis", die in dieser Schrift als x-Achse bezeichnet wird, einen deutlich größeren Abstrahlwinkel aufweist als in einer rechtwinkelig hierzu stehenden Richtung einer sogenannten "slow-axis", die in dieser Schrift als y-Achse bezeichnet wird. Beispielsweise beträgt die Divergenz in y-Richtung +/- 5° und die Divergenz in x-Richtung +/- 33°. Die Strahlachsen der Laserstrahlen der Laserdioden liegen parallel zueinander und parallel zu einer rechtwinkelig zur x- und y-Achse stehenden z-Achse.

Bei Laserdioden-Stacks, die auch als Laserdioden-Stapel bezeichnet werden, werden mehrere solcher Barren mit ihren Breitseiten und/oder Schmalseiten nebeneinander angeordnet. Ein kommerziell erhältlicher Laserdioden-Stack besteht beispielsweise aus 8 in x-Richtung nebeneinander angeordneten Barren mit jeweils 40 in y-Richtung beabstandeten Einzelemittern, wobei die emittierte optische Spitzenleistung 2.400 W bei einer Wellenlänge von 808 nm aus einer emittierenden Fläche von 10mm x 11.9mm beträgt. Andere Anzahlen von Barren und/oder Einzelemittern sind ebenfalls bekannt.

Die von einem solchen Laserdioden-Stack emittierte Laserstrahlung divergiert somit stark, wodurch die Abbildung mit optischen Bauteilen, mit denen die Laserstrahlung zusammenwirkt, damit an Grenzen hinsichtlich Apertur und Abbildungsqualität stößt. Um dem entgegenzuwirken, ist es bekannt, vor den Laserdioden eines jeweiligen Barrens eine Mikrolinse in Form einer Zylinderlinse anzuordnen. Die Zylinderachsen der Mikrolinsen sind in y-Richtung ausgerichtet, sodass die starke Divergenz in der x-Richtung reduziert wird, z.B. auf unter 1°. Dadurch wird die nachfolgende Optik zur Abbildung der Laserstrahlung in das verstärkende Lasermedium wesentlich vereinfacht. Allerdings kommt es durch den Einsatz solcher "fast-axis-collimation"-Mikrolinsen zu erhöhten Material- und Montagekosten (aufgrund enger Toleranzerfordernisse) und zu Leistungseinbußen, die etwa im Bereich von 10% liegen.

Weiters bekannt sind in die z-Richtung sich erstreckende, beispielsweise stab- oder pyramidenstumpfförmige optische Bauteile, von denen die Laserstrahlung mittels Totalreflektion zum verstärkenden Lasermedium geleitet wird, vgl. z.B. Eric C. Honea et al.: "Analysis of an intracavity-doubled diode-pumped Q-switched Nd:YAG laser producing more than 100 W of power at 0.532 µm", OPTICS LETTERS, Vol. 23, No. 15, 1. August 1998, Seiten 1203 bis 1205 und WO 2010/052308 A1. Ein Nachteil ist hier insbesondere die erforderliche Baulänge in z-Richtung, wodurch die Kompaktheit des gesamten Lasers verringert wird. Xiuhua Ma et. al.: "Conductively cooled all-solid-state zigzag slab laser", CHINESE OPTICS LETTERS, Vol. 6, No. 5, 10. Mai 2008, Seiten 366-368 offenbart einen Laser gemäß der Präambel des Anspruchs 1 bei dem Pumplicht eines Laserdioden-Stacks mittels einer plankonvexen Zylinderlinse kollimiert und auf einen plattenförmigen Nd:YAG Kristall gerichtet wird.

EP 0 717 476 A1 offenbart eine Anordnung zur Fokussierung der Strahlung eines Laserdioden-Stacks auf eine optische Faser mit Hilfe eines optischen Bauteils das eine Eintrittsfläche, eine Austrittstrittsfläche und eine gekrümmte Reflexionsfläche aufweist.

Aufgabe der Erfindung ist es, einen seitengepumpten Festkörperlaser mit einer vorteilhafte Pumpeinrichtung der eingangs genannten Art bereitzustellen, die bei einer hohen Effizienz eine kompakte Ausbildung ermöglicht. Erfindungsgemäß gelingt dies mit den Merkmalen des Anspruchs 1.

Bei der Pumpeinrichtung gemäß der Erfindung erstreckt sich die Zylinderfläche parallel zur x-Achse und ist in der y-z-Ebene gekrümmt, also in einer rechtwinklig zur x-Achse stehenden Ebene. Die Zylinderfläche hat damit eine abbildende, insbesondere sammelnde Wirkung in der y-z-Ebene (also bezüglich der "slow-axis") nicht hingegen in der x-z-Ebene (also bezüglich der "fast-axis").

Wenn man die von einer jeweiligen Laserdiode emittierte Laserstrahlung als Laserstrahl mit einem Strahlungskegel auffasst, innerhalb von welchem 95% der Gesamtleistung der von der Laserdiode emittierten Laserstrahlung liegt, so werden die Schnittlinien des Mantels des Strahlungskegels mit einer parallel zur y-z-Ebene liegenden und durch die Strahlachse verlaufenden Ebene im Weiteren als die auf die y-z-Ebene bezogenen Randstrahlen des Laserstrahls bezeichnet. Der Abstrahlwinkel dieser Randstrahlen entspricht dem halben gesamten Öffnungswinkel des Strahlungskegels in der parallel zur y-z-Ebene liegenden, durch die Strahlachse verlaufenden Ebene. Analoges gilt für die auf die x-z-Ebene bezogenen Randstrahlen des Laserstrahls. Der Abstrahlwinkel ist also der Winkel, den ein jeweiliger Randstrahl mit der Strahlachse einschließt, und definiert somit die Divergenz des von der Laserdiode ausgehenden Laserstrahls bezogen auf die y-z-Ebene oder bezogen auf die x-z-Ebene.

Die sammelnde Wirkung der Zylinderfläche in der y-z-Ebene bedeutet, dass durch das Zusammenwirken mit der Zylinderfläche zumindest das Auseinanderlaufen der auf die y-z-Ebene bezogenen Randstrahlen verringert wird oder diese Randstrahlen nach dem Zusammenwirken mit der Zylinderfläche parallel zueinander laufen (d.h. der Öffnungswinkel des Strahlungskegels ist Null, der Laserstrahl ist also kollimiert) oder sogar aufeinander zu laufen (d.h. der Öffnungswinkel des Strahlungskegels ist negativ).

Vorzugsweise schließen für einen jeweiligen Laserstrahl die beiden auf die y-z-Ebene bezogenen Randstrahlen nach dem Zusammenwirken mit der Zylinderfläche einen Winkel von weniger als 10° miteinander ein, d.h. die Laserstrahlen sind zumindest weitgehend kollimiert.

In einer vorteilhaften Ausführungsform der Erfindung weist die Pumpeinrichtung keine spiegelnde oder brechende Fläche auf, welche nur oder auch in einer rechtwinkelig zur y-Achse stehenden Ebene, also in der x-z-Ebene gekrümmt ist und mit der die Laserstrahlen zusammenwirken, die mit der in der y-z-Ebene gekrümmten Zylinderfläche zusammenwirken.

Die von zumindest mehreren Laserdioden, vorzugsweise zumindest dem Großteil der Laserdioden, besonders bevorzugt allen Laserdioden, der Strahlungsquelle emittierten Laserstrahlen wirken mit dieser parallel zur x-Achse liegenden und in der y-z-Ebene gekrümmten Zylinderfläche zusammen, also mit der gleichen Zylinderfläche. D.h. es ist für die von mehreren Laserdioden, vorzugsweise dem Großteil der Laserdioden, besonders bevorzugt allen Laserdioden, abgegebenen Laserstrahlen ein gemeinsames optisches Bauteil mit mindestens einer solchen Zylinderfläche vorgesehen, mit der diese Laserstrahlen zusammenwirken. Erfindungsgemäß ist die Zylinderfläche reflektierend (=spiegelnd) ausgebildet, sodass die Laserstrahlen an der Zylinderfläche reflektiert werden (abgesehen von Verlusten). Die Zylinderfläche ist zur Seite hin, von der die Laserstrahlen einfallen, konkav, wobei die Laserstrahlen durch eine Eintrittsfläche in das Bauteil eintreten und im Inneren des Bauteils an der Zylinderfläche reflektiert werden. Die Zylinderfläche kann in diesem Fall von einer verspiegelten zylindrischen Oberfläche (= Außenfläche) des Bauteils gebildet werden. Grundsätzlich denkbar und möglich wäre es auch, ein Bauteil mit einer verspiegelten inneren Zylinderfläche vorzusehen. Die von der Zylinderfläche reflektierten Laserstrahlen treten durch eine Austrittsfläche des Bauteils aus dem Bauteil aus. Die Eintrittsfläche und die Austrittsfläche werden von unterschiedlichen Oberflächen des optischen Bauteils gebildet, d.h. die Eintritts- und die Austrittsfläche sind räumlich voneinander getrennt.

Die Zylinderfläche des optischen Bauteils wird von einem Teil des gesamten Umfangs eines Zylindermantels, insbesondere eines geraden Zylinders, gebildet, d.h. sie stellt einen über einen bestimmten Polarwinkelbereich <2π sich erstreckenden Teil eines Zylindermantels dar. Es kann sich hierbei beispielsweise um die Mantelfläche eines Kreiszylinders, parabolischen Zylinders oder elliptischen Zylinders handeln. Derartige Zylinderflächen weisen eine Zylinderachse auf, die somit parallel zur x-Achse liegt.

Die Zylinderfläche besitzt günstigerweise eine Brennlinie (=Fokuslinie) auf der sich Strahlen, die parallel zu einer optischen Achse des Bauteils von einer Seite her einfallen, schneiden oder zumindest annähernd schneiden.

In einer vorteilhaften Ausführungsform der Erfindung befindet sich im Strahlenverlauf der von den Laserdioden emittierten Laserstrahlen zwischen den Laserdioden und dem die mindestens eine parallel zur x-Achse liegende und in der x-z-Ebene gekrümmte Zylinderfläche aufweisenden optischen Bauteil kein anderes optisches Bauteil, mit dem die Laserstrahlen zusammenwirken, d.h. die von den Laserdioden emittierten Laserstrahlen gelangen von den Laserdioden nach Durchlaufen einer Luftstrecke unmittelbar in das optische Bauteil.

Die Strahlungsquelle umfasst vorzugsweise zwei oder mehr bezogen auf die x-Achse an unterschiedlichen Stellen angeordnete Laserdioden, deren Laserstrahlen mit der Zylinderfläche des optischen Bauteils zusammenwirken, und besonders bevorzugt auch zwei oder mehr bezogen auf die y-Achse an unterschiedlichen Stellen angeordnete Laserdioden, deren Laserstrahlen mit der Zylinderfläche des optischen Bauteils zusammenwirken. In einer vorteilhaften Ausführungsform der Erfindung wirken die Laserstrahlen aller Laserdioden der Strahlungsquelle mit der Zylinderfläche des optischen Bauteils zusammen.

Vorzugsweise liegen alle Laserdioden der Strahlungsquelle in einer gemeinsamen, rechtwinkelig zur z-Achse stehenden Ebene (also in einer x-y-Ebene).

Eine bevorzugte Ausführungsform der Erfindung sieht vor, dass es sich bei der Strahlungsquelle um einen Laserdioden-Stack handelt, der mehrere Barren mit jeweils mehreren Laserdioden aufweist, wobei die Laserdioden eines jeweiligen Barrens in y-Richtung beabstandet angeordnet sind, also auf einer gemeinsamen, parallel zur y-Achse liegenden Geraden liegen. Hierbei sind vorzugsweise mindestens zwei Barren, in einer möglichen Ausführungsform der Erfindung alle Barren, bezogen auf die Richtung der x-Achse nebeneinanderliegend angeordnet, es handelt sich also um einen vertikalen Laserdioden-Stack, dessen Laserdioden in mehreren in y-Richtung verlaufenden Reihen (vorzugsweise drei oder mehr) und in mehreren in x-Richtung verlaufenden Spalten (vorzugsweise zehn oder mehr) angeordnet sind.

Um die von den Laserdioden emittierten Laserstrahlen in x-Richtung, also in Richtung der "fast-axis" zu führen, damit die von der Strahlungsquelle emittierte Laserstrahlung sich in diese Richtung nicht über einen zu großen räumlichen Bereich verteilt, sind erfindungsgemäß reflektierende Begrenzungsflächen vorgesehen sind, welche die insgesamte Ausdehnung der von der Strahlungsquelle emittierten Laserstrahlung in Richtung der x-Achse beidseitig begrenzt. Von diesen, vorzugsweise planen (= ebenen) Begrenzungsflächen werden die auf sie auftreffenden Strahlteile der von den Laserdioden emittierten Laserstrahlen reflektiert. Die Begrenzungsflächen liegen vorzugsweise rechtwinklig zur x-Achse. Die Erfindung sieht hierbei vor, dass das optische Bauteil, welches die mindestens eine parallel zur x-Achse liegende und in der y-z-Ebene gekrümmte Zylinderfläche aufweist, auch die reflektierenden Begrenzungsflächen besitzt. Diese werden also von Seitenflächen des optischen Bauteils gebildet, die vorzugsweise rechtwinkelig zur Eintritts- und Austrittsfläche des optischen Bauteils stehen. Günstigerweise erfolgt die Reflektion an den reflektierenden Begrenzungsflächen durch Totalreflektion.

Ein erfindungsgemäßer Laser ist insbesondere gepulst. Eine Ausbildung als Dauerstrich-Laser ist aber ebenfalls möglich.

Das verstärkende Lasermedium des Lasers ist durch die Pumpeinrichtung seitengepumpt. Beispielsweise handelt es sich um einen Plattenlaser (="slab laser"), z.B. Zick-Zack-Plattenlaser (=Laser mit "zig-zag slab gain medium"). Die Ein- und Austrittsflächen des Lasermediums für die vom verstärkenden Lasermedium emittierte Laserstrahlung, die im Resonator des Lasers geführt ist, können hierbei vorteilhafterweise im Brewster-Winkel angeordnet sein. Weitere Vorteile und Einzelheiten der Erfindung werden im Folgenden anhand der beiliegenden Zeichnung erläutert. In dieser zeigen:
Fig. 1 eine stark schematisierte Darstellung eines Ausführungsbeispiels für einen in erfindungsgemäßer Weise gepumpten Laser;
Fig. 2 ein Ausführungsbeispiel einer Strahlungsquelle für eine erfindungsgemäße Pumpeinrichtung, in Ansicht von vorne;
Fig. 3 die Strahlungsquelle von Fig. 2 in Seitenansicht;
Fig. 4 die Strahlungsquelle von Fig. 2 in einer Ansicht von oben;
Fig. 5 eine Schrägsicht der Strahlungsquelle von Fig. 2;
Fig. 6 eine Schrägsicht einer ersten Ausführungsform einer erfindungsgemäßen Pumpeinrichtung in Schrägsicht zusammen mit dem zu pumpenden verstärkenden Lasermedium;
Fig. 7 eine Darstellung der axialen Strahlen der Strahlenbündel der einzelnen Laserdioden in der x-z-Ebene;
Fig. 8 eine Darstellung der axialen Strahlen in der y-z-Ebene;
Fig. 9 eine Darstellung der auf die x-z-Ebene und y-z-Ebene bezogenen Randstrahlen der Strahlungskegel von drei der Laserdioden in einer Projektion in die x-z-Ebene;
Fig. 10 eine Darstellung der auf die x-z-Ebene und y-z-Ebene bezogenen Randstrahlen der Strahlungskegel von drei der Laserdioden in einer Projektion in die y-z-Ebene;
Fig. 11 bis 14 Darstellungen analog den Fig. 7 bis 10 für eine Abwandlung der Erfindung;
Fig. 15 und 16 Darstellungen analog den Fig. 9 und 10 für eine Abwandlung der Erfindung.

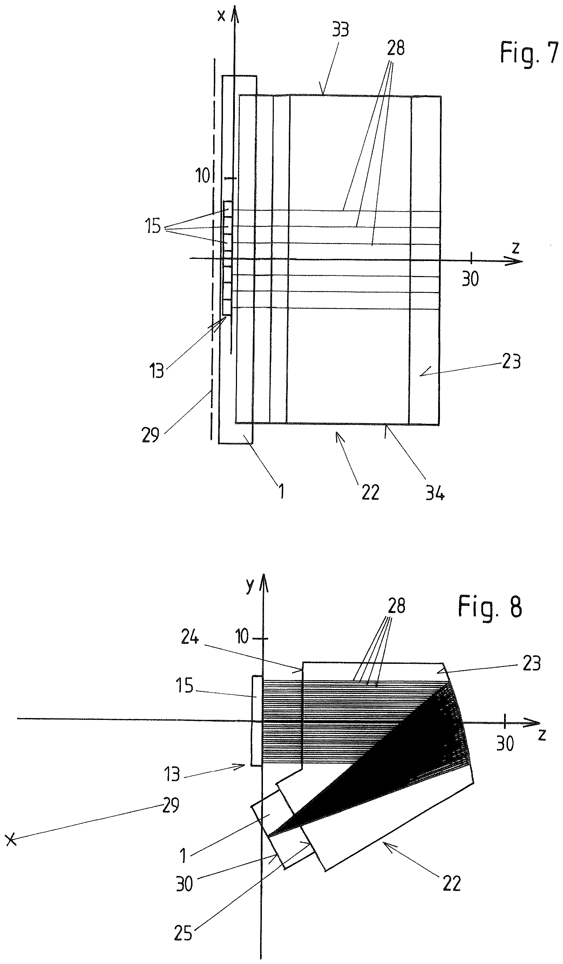

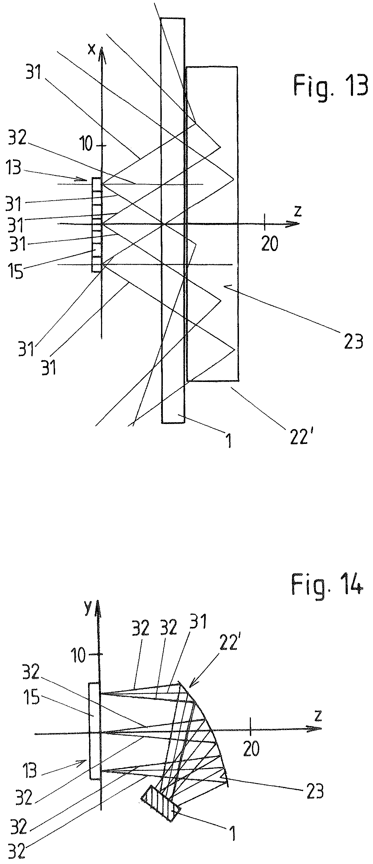

Die Zeichnungen weisen unterschiedliche Maßstäbe auf. Die in den Fig. 7 bis 16 eingetragenen Einheiten sind mm.

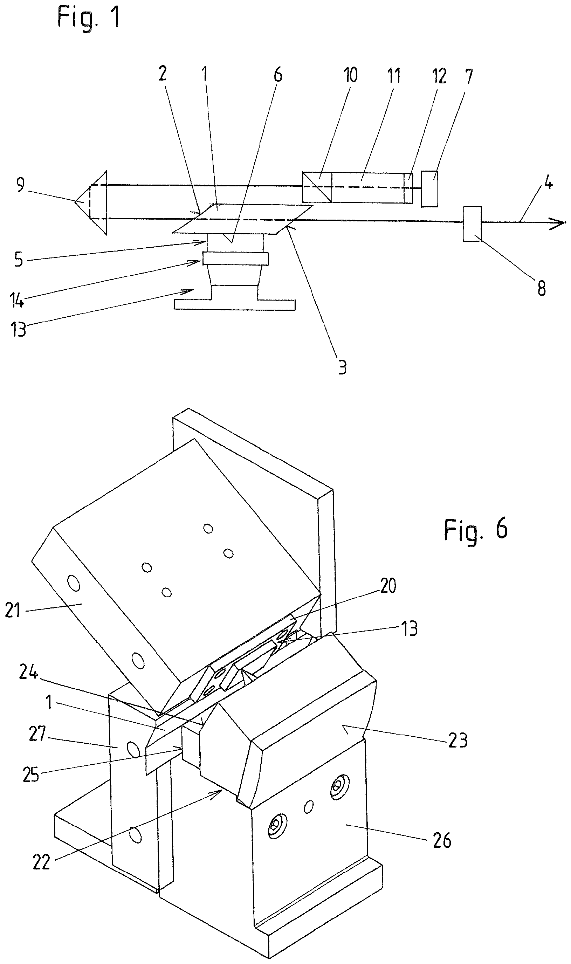

Eine mögliche Ausführungsform für einen erfindungsgemäßen Laser ist schematisch in Fig. 1 dargestellt. Es handelt sich um einen Festkörperlaser, dessen verstärkendes (aktives) Lasermedium aus einem kristallinen oder glasartigen (amorphen) Festkörper besteht. Beispielsweise kann das verstärkende Lasermedium 1 Nd:YAG, Nd:Glas, Nd:Vanadat oder Yb:YAG sein.

Das verstärkende Lasermedium ist in einem Resonator angeordnet, dessen Komponenten weiter unten genauer erläutert werden.

Das verstärkende Lasermedium 1 ist beispielsweise plattenförmig ausgebildet, es handelt sich also um einen Plattenlaser (="slab laser"). Obwohl der Strahl der vom verstärkenden Lasermedium 1 emittierten Laserstrahlung in Fig. 1 schematisch geradlinig durch das verstärkende Lasermedium 1 verlaufend dargestellt ist, könnte es auch Zick-Zack-förmig durch diesen verlaufen. Die beiden Ein- und Austrittsflächen 2, 3 für die vom Lasermedium 1 emittierte, den Resonator durchlaufende Laserstrahlung sind vorteilhafterweise im Brewster-Winkel angeordnet, was aber nicht zwingend erforderlich ist.

Das verstärkende Lasermedium 1 ist seitengepumpt, wie dies bekannt ist. Die das verstärkende Lasermedium 1 pumpende Laserstrahlung 5 fällt also nicht durch die Ein- und Austrittsflächen 2, 3 in das Lasermedium ein, sondern durch eine Seitenfläche 6. Diese steht winkelig zu den Ein- und Austrittsflächen 2, 3.

Das Lasermedium 1 könnte statt plattenförmig beispielsweise auch stabförmig ausgebildet sein.

Der Resonator umfasst einen Endspiegel 7 und einen Auskoppelspiegel 8, um den vom Laser abgegebenen Laserstrahl 4 auszukoppeln. Der dargestellte Resonator ist einmal gefaltet, zu welchem Zweck ein Umkehrprisma 9 im Strahlengang angeordnet ist. Die Faltung könnte auch entfallen oder der Resonator könnte mehrfach gefaltet sein. Andere Faltspiegel könnten vorgesehen sein.

Um einen Güteschalter auszubilden sind im Strahlengang des Resonators im dargestellten Ausführungsbeispiel ein Polarisator 10, eine Pockels-Zelle 11 und ein Lambda-Viertel-Plättchen 12 angeordnet. Die vom Laser abgegebene Laserstrahlung ist somit gepulst. Zur Ausbildung von Pulsen könnten auch andere als elektrooptische Güteschalter, insbesondere akustooptische Güteschalter vorgesehen sein.

Einer der im Strahlengang angeordneten Spiegel, insbesondere der Auskoppelspiegel 8 oder der Endspiegel 7 könnte wie bekannt als Gradientenspiegel ausgebildet sein, dessen Reflektivität sich über die Spiegelfläche ändert und hierbei in einem mittleren Bereich größer ist als in einem Randbereich. Dadurch kann das Strahlprofil des Laserstrahls beeinflusst werden, beispielsweise um einen rascheren Randabfall der Intensität zu erreichen, und/oder die Strahlqualität des Laserstrahls verbessert werden.

Das Pumpen des verstärkenden Lasermediums erfolgt mittels einer Strahlungsquelle 13, welche eine Mehrzahl von Laserdioden umfasst. Die Optik 14 der Pumpeinrichtung, um die von der Strahlungsquelle abgegebene Laserstrahlung in vorteilhafter Weise dem verstärkenden Lasermedium 1 zuzuführen, ist in Fig. 1 nur schematisch angedeutet.

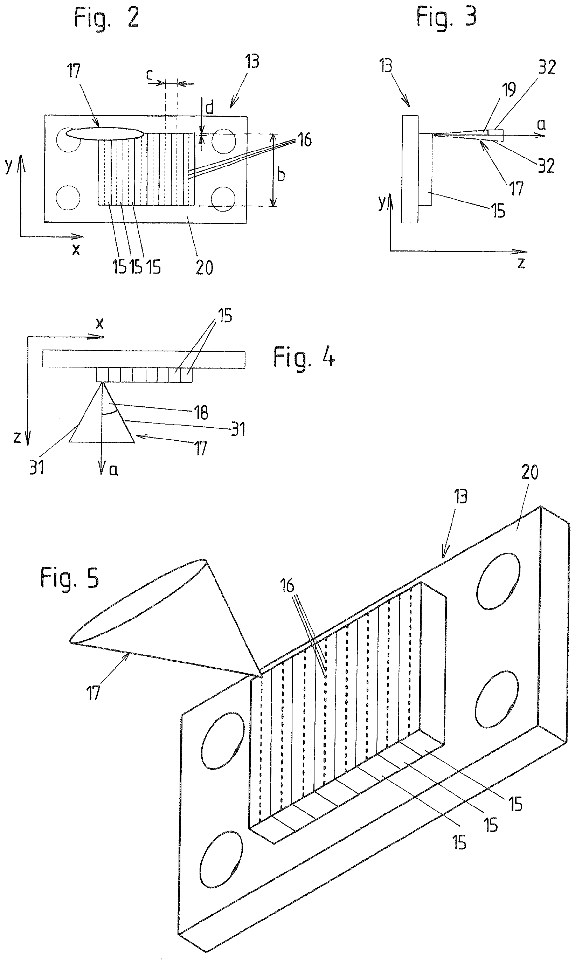

Die Strahlungsquelle 13 ist vorzugsweise in Form eines Laserdioden-Stacks ausgebildet und ein Beispiel hierfür ist in den Fig. 2 bis 5 dargestellt. Der Laserdioden-Stack umfasst mehrere Barren 15, welche jeweils mehrere Laserdioden 16 aufweisen, die in Richtung einer y-Achse voneinander beabstandet sind. Beispielsweise können pro Barren 15 zwanzig bis sechzig Laserdioden

(=Einzelemitter) 16 vorhanden sein. In Richtung einer rechtwinkelig zur y-Achse stehenden x-Achse sind mehrere solche Barren 15 nebeneinander angeordnet, deren Laserdioden 16 jeweils in y-Richtung voneinander beabstandet sind (jeweils auf einer parallel zur y-Achse angeordneten Geraden liegen). Beispielsweise können fünf bis fünfzehn Barren 15 vorhanden sein. Es könnten auch in y-Richtung zwei oder mehr Barren 15 nebeneinander angeordnet sein, sodass zwei oder mehr in x-Richtung verlaufende Reihen von nebeneinander angeordneten Barren 15 vorhanden wären.

Für eine der Laserdioden 16 der Strahlungsquelle 13 ist der Strahlungskegel des von ihr emittierten Laserstrahls 17 dargestellt. Die Strahlachse a liegt parallel zur rechtwinkelig zur x- und y-Achse stehenden z-Achse. Die Strahlachsen a aller Laserdioden 16 der Strahlungsquelle 13 liegen parallel zueinander, wobei die Laserdioden 16 jeweils die gleiche Strahlungscharakteristik aufweisen.

Ein jeweiliger Strahlungskegel einer Laserdiode ist in dieser Schrift dadurch definiert, dass er den Bereich begrenzt, innerhalb von dem 95% der insgesamt von der Laserdiode emittierten Leistung der Laserstrahlung emittiert wird.

Als auf die x-z-Ebene bezogenen Randstrahlen 31 einer jeweiligen der Laserdioden werden in dieser Schrift die Linien bezeichnet, die den Strahlungskegel in einem Schnitt des Strahlungskegels mit einer parallel zur x-z-Ebene liegenden und durch die Strahlachse a verlaufenden Ebene begrenzen. Als auf die y-z-Ebene bezogenen Randstrahlen 31 einer jeweiligen der Laserdioden werden in dieser Schrift die Linien bezeichnet, die den Strahlungskegel in einem Schnitt des Strahlungskegels mit einer parallel zur y-z-Ebene liegenden und durch die Strahlachse a verlaufenden Ebene begrenzen.

Mit anderen Worten könnte auch gesagt werden, dass durch die Randstrahlen 31 für eine jeweilige Laserdiode der Bereich in einer zur x-Achse und zur z-Achse parallelen, durch die Strahlachse a verlaufenden Ebene begrenzt ist, innerhalb von dem 95% der Gesamtleistung der von der Laserdiode abgegebenen Laserstrahlung emittiert wird. In analoger Weise begrenzen die Randstrahlen 32 in einer zur y-Achse und zur z-Achse parallelen, durch die Strahlachse a verlaufenden Ebene einen solchen Bereich.

Der auf die x-z-Ebene bezogene Abstrahlwinkel 18 ist der Winkel zwischen dem jeweiligen Randstrahl 31 und der Strahlachse a. Der auf die y-z-Ebene bezogene Abstrahlwinkel 19 ist der Winkel zwischen dem jeweiligen Randstrahl 32 und der Strahlachse a.

Wenn in dieser Schrift davon die Rede ist, dass Strahlen in der x-z-Ebene oder in der y-z-Ebene dargestellt sind, so ist jeweils die Projektion in die x-z-Ebene bzw. y-z-Ebene gemeint.

Die von den Laserdioden 16 emittierten Laserstrahlen 17 besitzen in Richtung der x-Achse eine mindestens doppelt so große, vorzugsweise mindestens dreimal so große, Divergenz wie in Richtung der y-Achse. Es ist also der auf die x-z-Ebene bezogene Abstrahlwinkel 18 mindestens doppelt so groß, vorzugsweise mindestens dreimal so groß, wie der auf die y-z-Ebene bezogene Abstrahlwinkel 19. Beispielsweise kann der Abstrahlwinkel 18 +/-33° betragen und der Abstrahlwinkel 19 +/-5°.

Die Barren 15 sind auf einem Träger 20 gehalten. In Fig. 6 ist ein Kühlkörper 21 zur Kühlung des Laserdioden-Stacks dargestellt, der beispielsweise wassergekühlt sein kann (die Anschlüsse sind nicht dargestellt). Die Elektronik zum Betreiben des Laserdioden-Stacks ist in Fig. 6 der Übersichtlichkeit halber nicht dargestellt.

Die Pumpeinrichtung umfasst im Weiteren ein optisches Bauteil 22, das eine Zylinderfläche 23 aufweist. Diese wird in diesem Ausführungsbeispiel von einer mit einer reflektierenden Beschichtung versehenen äußeren Oberfläche des optischen Bauteils 22 gebildet. Die von den Laserdioden 16 der Strahlungsquelle 13 emittierten Laserstrahlen 17 gelangen durch eine Eintrittsfläche 24 des optischen Bauteils 22 in dieses (zumindest großteils). Nachdem die Laserstrahlen 17 an der Zylinderfläche 23 reflektiert worden sind, treten die Laserstrahlen 17 aus der Austrittsfläche 25 des Bauteils 22 aus (zumindest großteils). Die Eintrittsfläche 24 und die Austrittsfläche 25 sind günstigerweise mit Antireflexionsbeschichtungen versehen.

Die durch die Austrittsfläche 25 austretenden Laserstrahlen gelangen auf das Lasermedium 1 (zumindest großteils). Die Eintrittsfläche 24 und die Austrittsfläche 25 werden von unterschiedlichen Oberflächen des Bauteils 22 gebildet, überlappen sich also nicht.

Im gezeigten Ausführungsbeispiel liegt das verstärkende Lasermedium 1 mit der Seitenfläche 6, durch welches es gepumpt wird, direkt an der Austrittsfläche 25 des optischen Bauteils 22 an. Es könnte auch, beispielsweise um die Totalreflexion bei einem Zick-Zack-Laser zu gewährleisten, ein kleiner dazwischen liegender Spalt vorgesehen sein oder ein dazwischen liegendes transparentes Material, welches einen geringeren Brechungsindex als das Material des verstärkenden Lasermediums 1 aufweist. Zumindest ist der in Richtung der Oberflächennormalen auf die Seitenfläche 6 gemessene Abstand des Lasermediums 1 von der Austrittsfläche 25 günstigerweise kleiner als die in diese Richtung gemessene Ausdehnung des Lasermediums 1.

Im Ausführungsbeispiel handelt es sich bei dem die Zylinderfläche 23 aufweisenden optischen Bauteil 22 um das einzige optische Bauteil der Pumpeinrichtung, mit der die von der Strahlungsquelle 13 abgegebene Laserstrahlung zusammenwirkt. Vorzugsweise ist zumindest nur ein optisches Bauteil vorhanden, welches eine abbildende, insbesondere sammelnde, Wirkung hat.

Um den Durchtritt der Laserstrahlen 17 durch das Bauteil 22 zu ermöglichen, besteht dieses aus einem transparenten Material. Vorzugsweise liegt die Transmission des Materials des optischen Bauteils 22 bei der Wellenlänge der Laserstrahlen 17 (= die Wellenlänge des Maximums der Intensität) bei mehr als 99%, vorzugsweise mehr als 99,5%, über eine Wegstrecke von 10mm (reine Materialtransmission, keine Oberflächenreflexe berücksichtigt). In praktischen Ausführungsformen kann der Wert bei über 99,8% liegen. Die gesamte Absorption der durch das optische Bauteil 22 laufenden Laserstrahlung der Strahlungsquelle 13 kann günstigerweise unter 3%, besonders bevorzugt unter 1% liegen. Die von der Laserstrahlung 5 durchlaufene Wegstrecke kann hierbei kürzer als 20cm, vorzugsweise kürzer als 10cm sein. Beispielsweise kann das optische Bauteil aus Glas, z.B. SF6 oder SF11,bestehen. Andere transparente Materialien sind ebenfalls einsetzbar, beispielsweise YAG.

Der Brechungsindex n des Materials des optischen Bauteils 22 ist bei der Wellenlänge der von der Strahlungsquelle 13 abgegebenen Laserstrahlung im Ausführungsbeispiel größer als 1,6. Der Brechungsindex des hochbrechenden Glasmaterials SF6 beträgt n=1.78 bei einer Wellenlänge von 808 nm.

In anderen Ausführungsbeispielen könnte auch ein Material mit einem geringeren Brechungsindex als 1,6 zum Einsatz kommen, z.B. ein Silikatglas.

In Fig. 6 ist dargestellt, dass das optische Bauteil 22 aus mehreren, insbesondere durch Verklebung miteinander verbundenen, aus transparentem Material bestehenden Teilen ausgebildet ist. Auch eine einteilige Ausbildung ist denkbar und möglich. Das optische Bauteil 22 ist an einem Träger 26 befestigt.

In Fig. 6 ist weiters ein Kühlkörper 27 dargestellt, der beispielsweise wassergekühlt ist (die Anschlüsse sind nicht dargestellt) und zur Kühlung des verstärkenden Lasermediums 1 dient.

Wenn man die von den Laserdioden 16 emittierten Laserstrahlen 17 jeweils als Strahlenbündel auffasst, so sind in Fig. 7 und 8 die axialen Strahlen 28 der Strahlenbündel dargestellt, also die entlang der Strahlachsen a der Laserdioden 16 emittierten Strahlen, und zwar in Fig. 7 in der x-z-Ebene (eine Projektion in die x-z-Ebene wäre hier identisch) und in Fig. 8 in der y-z-Ebene (eine Projektion in die y-z-Ebene wäre hier identisch). Die Fig. 7 und 8 stellen also auch den Verlauf der optischen Achsen der von den Laserdioden 16 emitierten Laserstrahlen 17 in der x-z-Ebene bzw. in einer Projektion in die x-z-Ebene und in der y-z-Ebene bzw. in einer Projektion in die y-z-Ebene dar. Die als Laserdioden-Stack ausgebildete Strahlungsquelle 13, das optische Bauteil 22 und das verstärkende Lasermedium 1 sind schematisch eingezeichnet.

Der 0-Punkt der x- und y-Achse sind in das Zentrum der Strahlungsquelle 13 gelegt. Der 0-Punkt der z-Achse liegt an der Oberfläche der Strahlungsquelle 13, von der die Laserstrahlung abgegeben wird.

Bezogen auf die x-Richtung erfolgt durch das optische Bauteil 22 keine Beeinflussung der axialen Strahlen 28. Die axialen Strahlen 28 laufen in der x-z-Ebene bzw. in einer Projektion auf die x-z-Ebene parallel zur z-Achse von der Strahlungsquelle 13 bis zum verstärkenden Lasermedium 1.

Bezogen auf die y-z-Ebene werden die axialen Strahlen 28, die bis zur Zylinderfläche 23 parallel zueinander in die z-Richtung verlaufen, von der Zylinderfläche 23 derart reflektiert, dass sie auf einen Punkt zusammenlaufen. Räumlich betrachtet laufen die axialen Strahlen 28 auf einer parallel zur x-Achse und rechtwinklig zur y-z-Ebene liegenden Schnittlinie zusammen (zumindest näherungsweise), die die Brennlinie der Zylinderfläche 23 darstellt.

Das Lasermedium 1 ist hier so angeordnet, dass die (näherungsweise) Schnittlinie der axialen Strahlen 28 im Bereich der dem optischen Bauteil 22 abgewandten Seitenfläche 30 liegt. Diese Seitenfläche 30 ist hier günstigerweise verspiegelt, sodass sie die auf sie auftreffenden Laserstrahlen 17 zurück reflektiert. Die Schnittlinie könnte auch in einem mittleren Bereich des verstärkenden Lasermediums 1 liegen oder auch im Bereich der Seitenfläche 6. Da eine Anlage der Seitenfläche 6 an der Austrittsfläche 25 des optischen Bauteils 22 bevorzugt ist, könnte diesen Fällen die Geometrie des optischen Bauteils entsprechend angepasst werden.

In den Fig. 7 und 8 ist auch die Zylinderachse 29 eingezeichnet, um welche die Zylinderfläche 23 gekrümmt ist. Beispielsweise wird die Zylinderfläche 23 von einem Umfangsteil eines Mantels eines geraden Kreiszylinders gebildet, der um die Zylinderachse 29 gekrümmt ist. Es könnte sich z.B. auch um einen um die Zylinderachse 29 gekrümmten parabolischen oder elliptischen Zylinder handeln.

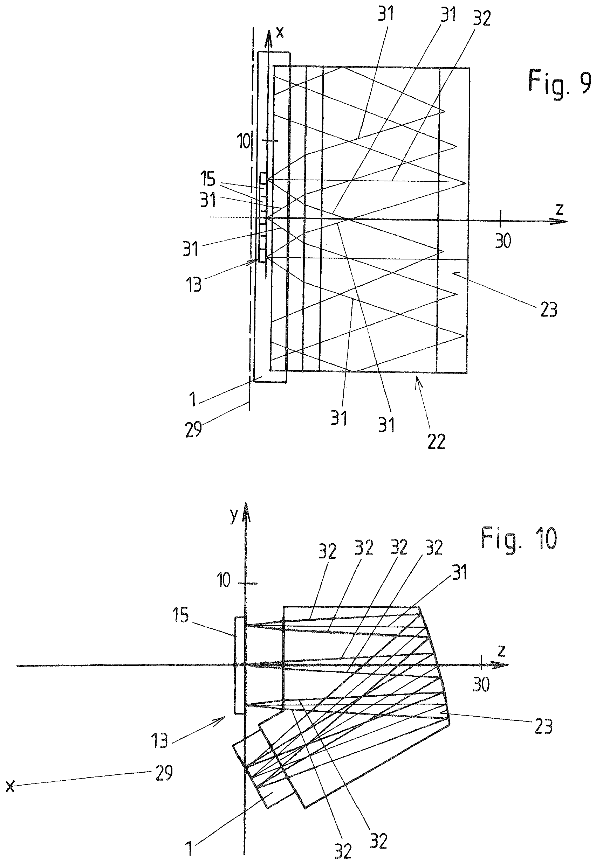

Die Fig. 9 und 10 zeigen zu den Fig. 7 und 8 analoge Darstellungen, wobei hier aber die Projektion der Randstrahlen 31, 32 in die x-z-Ebene und in die y-z-Ebene für die von drei der Laserdioden 16 emittierten Laserstrahlen 17 dargestellt ist. Es handelt sich um zwei randseitige Laserdioden 16 (von denen also die eine die größten Werte der x- und y-Koordinaten und von denen die andere die kleinsten Werte der x- und y-Koordinaten aller Laserdioden aufweist) sowie um eine bezogen auf die x- und y-Ausdehnung der Strahlungsquelle 13 in einem zentralen Bereich liegende Laserdiode 16. Fig. 9 zeigt die Projektion in die x-z-Ebene und Fig. 10 zeigt die Projektion in die y-z-Ebene.

Da der Brechungsindex n des Materials des Bauteils 22 größer als Luft ist, werden die Winkel der Randstrahlen 31, 32 zur z-Achse beim Eintritt des jeweiligen Laserstrahls 17 in das optische Bauteil 22 dem Verhältnis der Brechungsindizes entsprechend reduziert.

Die auf die Zylinderfläche 23 auftreffenden Randstrahlen werden von dieser reflektiert. In Bezug auf die x-z-Ebene erfolgt hierbei keine Änderung der Divergenz der beiden Randstrahlen 31 des Laserstrahls 17 einer jeweiligen Laserdiode 16. Im Bezug auf die y-z-Ebene verlaufen die beiden Randstrahlen 32 des Laserstrahls 17 einer jeweiligen Laserdiode 16 im Ausführungsbeispiel nach der Reflexion durch die Zylinderfläche 23 parallel. Es könnte auch eine Ausbildung vorgesehen sein, sodass die beiden Randstrahlen 32 eines jeweiligen Laserstrahls 27 nach der Reflexion an der Zylinderfläche 23 zusammenlaufen (konvergieren). Zumindest wird die Divergenz der beiden Randstrahlen 32 eines jeweiligen Laserstrahls 17 in Folge der Reflexion an der Zylinderfläche 23 in der y-z-Ebene verringert.

Die Zylinderfläche 23 entfaltet also eine sammelnde Wirkung für die von den Laserdioden 16 emittierten Laserstrahlen 17 bezogen auf die y-z-Ebene, nicht aber bezogen auf die x-z-Ebene oder mit anderen Worten eine sammelnde Wirkung hinsichtlich der ursprünglichen Divergenz in y-Richtung (=in Richtung der "slowaxis") nicht aber hinsichtlich der ursprünglichen Divergenz in x-Richtung (=in Richtung der "fast-axis").

In diesem Ausführungsbeispiel treffen Strahlteile der Laserstrahlen 17 der randseitigen Laserdioden 16 nach der Reflexion an der Zylinderfläche 23 auf Begrenzungsflächen 33, 34 des optischen Bauteils 22 auf, welche das optische Bauteil 22 in x-Richtung begrenzen und vorzugsweise rechtwinklig zur x-Achse stehen. An diesen Begrenzungsflächen 33, 34 erfolgt eine Totalreflexion der auf sie auftreffenden Teilstrahlen. Die Reflexion ist für die entsprechenden Randstrahlen 31 in Fig. 10 dargestellt. Auch für andere als die von den beiden randseitigen Laserdioden emittierten Laserstrahlen 17 erfolgt eine Reflexion von Teilstrahlen an den Begrenzungsflächen 33, 34. Damit wird die Ausdehnung der von der Strahlungsquelle 13 emittierten Laserstrahlung bezogen auf die x-Richtung begrenzt. Die Geometrie der Anordnung könnte auch so gewählt sein, dass Teilstrahlen von Laserstrahlen 17 der Laserdioden 16 bereits vor Auftreffen auf die Zylinderfläche 23 an den Begrenzungsflächen 33, 34 reflektiert werden.

Bezogen auf die x-Achse erfolgt also eine Führung der Laserstrahlung durch interne Reflexion an den Begrenzungsflächen 33, 34. Falls die Erstreckung des Lasermediums 1 in die x-Achse ausreichend groß ist, könnte die Reflexion an den Begrenzungsflächen 33, 34 auch entfallen (das optische Bauteil 22 wird dann in die x-Richtung ebenfalls entsprechend lang ausgebildet).

Insgesamt wird eine verlustarme, weitgehend homogene Ausleuchtung des Lasermediums 1 erreicht. Da ein starker Überlapp der von den einzelnen Laserdioden 16 emittierten Laserstrahlen 17 vorhanden ist, bleibt die Ausleuchtung auch dann noch relativ homogen, wenn einzelne der Laserdioden 16 ausfallen sollten.

Der Krümmungsradius der Zylinderfläche 23 liegt beispielsweise im Bereich von 30mm bis 100mm, im Ausführungsbeispiel bei 57,8mm. Entlang der z-Achse liegt die Entfernung von der Strahlungsquelle 13 beispielsweise im Bereich zwischen 13mm und 45mm, im Ausführungsbeispiel bei 25mm. Der Kippwinkel der Zylinderfläche gegenüber der Ausrichtung, in welcher die Zylinderfläche die z-Achse schneidet, liegt beispielsweise im Bereich 10° bis 25°, im Ausführungsbeispiel bei 15°.

Der Abstand zwischen der Strahlungsquelle 13 und der Zylinderfläche 23 soll so sein, dass die einzelnen Laserstrahlen nach ihrer Reflexion an der Zylinderfläche derart zumindest weitgehend kollimiert sind, dass die Randstrahlen 32 Winkel von zumindest weniger als 10° miteinander einschließen.

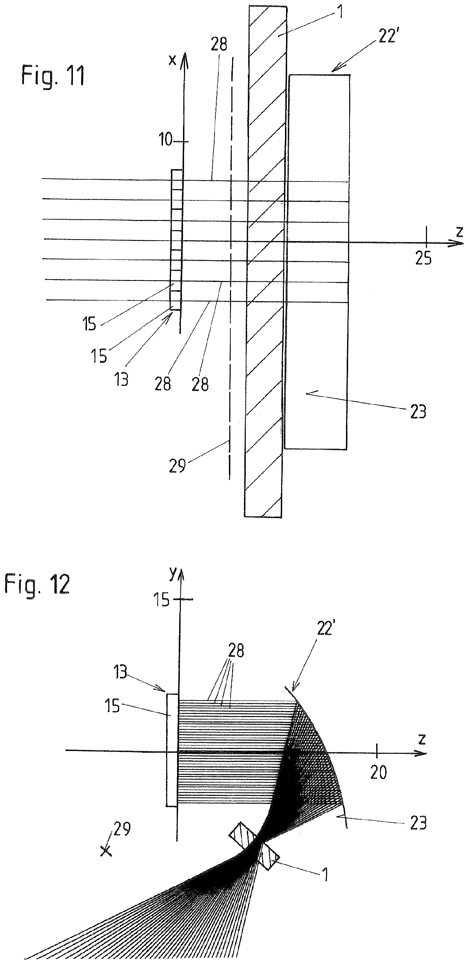

Die Fig. 11 bis 14 sind Darstellungen analog zu den Fig. 7 bis 10 für eine Abwandlung die nicht unter die Erfindung fällt. Als optisches Bauteil 22', welches die Zylinderfläche 23 aufweist, ist hier ein Zylinderspiegel vorgesehen. Die Zylinderfläche 23 kann beispielsweise von einem Umfangsteil des Mantels eines geraden Kreiszylinders gebildet sein, der um die Zylinderachse 29 gekrümmt ist, die rechtwinklig zur y-z-Ebene steht, also parallel zur x-Achse verläuft.

Der Strahlenverlauf ist ähnlich wie im zuvor beschriebenen Ausführungsbeispiel. Allerdings fehlt hier die Wirkung, dass die Divergenzwinkel beim Eintritt in ein Material mit einem Brechungsindex, der größer als der von Luft ist, verringert werden. Um eine bestimmungsgemäße Breite der Laserstrahlung in der Projektion auf die y-z-Ebene am Ort des verstärkenden Lasermediums zu erhalten, muss die Zylinderfläche 23 damit stärker gekrümmt sein als im ersten Ausführungsbeispiel. Insgesamt ergibt sich eine weniger ausgeprägte insgesamte minimale Einschnürung der Laserstrahlung in dem Bereich, in der das verstärkende Lasermedium 1 angeordnet wird. Die, insbesondere sphärischen, Aberrationen hinsichtlich des Überlapps der einzelnen Strahlen sind somit größer als im ersten Ausführungsbeispiel.

Der Krümmungsradius der Zylinderachse 23 kann beispielsweise im Bereich von 15mm bis 30mm liegen. Der Abstand von der Strahlungsquelle 13, entlang der z-Achse gemessen, liegt vorzugsweise etwa im Bereich des halben Krümmungsradius (+/- 10%).

Eine Reflexion an Begrenzungsflächen, die die Laserstrahlung bezogen auf die x-Richtung durch Reflexion begrenzen, ist in diesem Ausführungsbeispiel nicht dargestellt. Eine solche Begrenzung könnte aber vorhanden sein, indem Spiegel vorgesehen werden, welche solche reflektierende Begrenzungsflächen 33, 34 aufweisen. Die Begrenzungsflächen wären hierbei insbesondere wiederum eben und rechtwinklig zur x-Achse angeordnet.

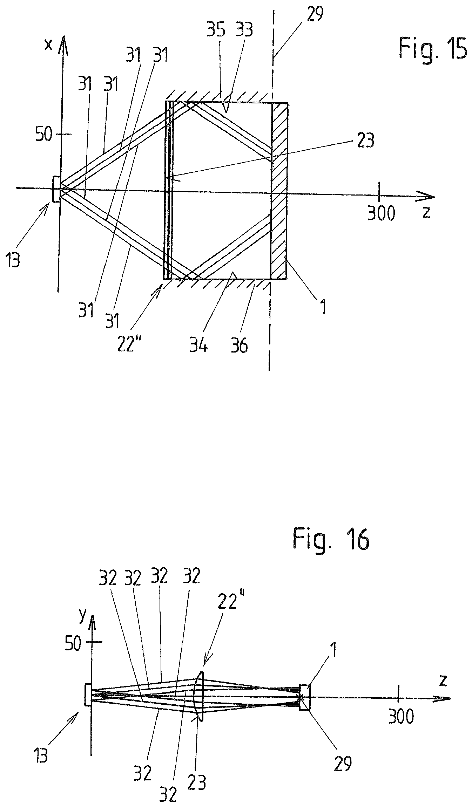

Die Fig. 15 und 16 zeigen Darstellungen analog zu den Fig. 9 und 10 bzw. 13 und 14 für eine weitere Abwandlung die nicht unter die Erfindung fällt.

In diesem Ausführungsbeispiel ist das optische Bauteil 22", welches die Zylinderfläche 23 aufweist, eine Zylinderlinse. Die Zylinderfläche kann beispielsweise von einem Umfangsteil des Mantels eines geraden Kreiszylinders gebildet sein, der um die Zylinderachse 29 gekrümmt ist, die rechtwinklig zur y-z-Ebene steht.

Das verstärkende Lasermedium 1 ist hier so angeordnet, dass die Seitenfläche 6, durch welche die von der Strahlungsquelle 13 emittierte Laserstrahlung eintritt, bezogen auf die z-Achse an der Stelle der Zylinderachse 37 liegt. Das Lasermedium 1 könnte auch so angeordnet sein, dass die Zylinderachse 37 innerhalb des Lasermediums 1 oder im Bereich der rückseitigen Seitenfläche 30 liegt. Die rückseitige Seitenfläche 30 könnte wiederum verspiegelt ausgebildet sein.

Die Brennweite der Zylinderlinse kann beispielsweise im Bereich von 50mm bis 200mm liegen, wobei der Abstand zwischen der Zylinderlinse und der Strahlungsquelle 13 im Bereich der Brennweite liegt (+/- 10%). Der Abstand zwischen der Zylinderlinse und dem Lasermedium 1 liegt ebenfalls im Bereich der Brennweite (+/- 10%).

Nach dem Durchlaufen durch das optische Bauteil 22" laufen die beiden Randstrahlen 32 des Laserstrahls 17 einer jeweiligen Laserdiode 16 vorzugsweise zusammen oder parallel zueinander. Zumindest wird die Divergenz der beiden Randstrahlen 32 vom optischen Bauteil 22" verringert. Das optische Bauteil 22" hat also bezogen auf die ursprüngliche Divergenz in der y-z-Ebene eine sammelnde Wirkung.

Bezogen auf die x-z-Ebene wird die Divergenz der beiden Randstrahlen 31 des Laserstrahls 17 einer jeweiligen Laserdiode 16 nicht verringert. Im Ausführungsbeispiel sind aber ebene Spiegel 35, 36 vorgesehen, deren Spiegelflächen Begrenzungsflächen 33, 34 für die Laserstrahlung bilden, wobei die Begrenzungsflächen 33, 34 rechtwinklig zur x-Achse stehen. Die Ausdehnung der Laserstrahlung der von der Strahlungsquelle 13 emittierten Laserstrahlung in die x-Richtung wird dadurch wiederum begrenzt.

Falls die Ausdehnung des Lasermediums 1 in die x-Richtung ausreichend groß ist, könnten die Begrenzungsflächen 33, 34 wiederum entfallen.

Die einzelnen Laserstrahlen 17 der Laserdioden 16 überlappen im Bereich des Lasermediums 1 gut. In Hinblick auf die relativ große Brennweite ist der von der Laserstrahlung beleuchtete Bereich aber relativ groß und das verstärkende Lasermedium 1 muss entsprechend groß ausgebildet sein.

Vorteilhafterweise beträgt die Fokuslänge der Zylinderlinse mehr als das Fünffache des auf die Richtung der y-Achse bezogenen Abstands zwischen den beiden in y-Richtung den größten Abstand voneinander aufweisenden Laserdioden der Strahlungsquelle.

Der Einsatz von Zylinderlinsen mit kürzeren Brennweiten ist möglich, allerdings geht dies mit Abstrichen in der Kollimation und der Homogenität der Ausleuchtung einher.

Die Zylinderfläche des Bauteils 22" könnte auch auf der dem Lasermedium 1 zugewandten Seite angeordnet sein. Auch eine Zylinderlinse mit beidseitigen Zylinderflächen könnte eingesetzt werden.

Durch die hier beschriebene Pumpeinrichtung lassen sich insbesondere kompakte seitengepumpte Festkörperlaser bereitstellen. Beispielsweise kann ein Laser mit mindestens 100 mJ Pulsenergie und Pulsen, die kürzer als 20 ns sind, realisiert werden. Der "foot print" (= Laserkopf ohne Elektronik) kann hierbei Abmessungen von weniger als 15cm x 10cm, vorzugsweise Abmessungen im Bereich von 10cm x 5cm, aufweisen und weniger als 2kg Masse besitzen, sodass er für "hand held"-Anwendungen geeignet ist.

Andererseits kann ein gepulster Laser mit größer als 3 mJ Pulsenergie und kleiner als 10 ns Pulslänge bereitgestellt werden, der Abmessungen von weniger als 10cm x 5cm oder noch weniger aufweist (wiederum Laserkopf, ohne Elektronik). Durch die Erfindung kann ein kompakter Pulslaser bereitgestellt werden, der eine hohe Effizienz von mehr als 10% oder sogar mehr als 15% aufweist, im Bezug auf die Energie des erzeugten Pulses im Verhältnis zur Energie des (optischen) Pumppulses. Aufgrund der Effizienz kann gegebenenfalls ein kompakter Pulslaser bereitgestellt werden, der keine Wasserkühlung benötigt. Gegebenenfalls kann ein 100 Hz/100 mJ Laser bereitgestellt werden, der in der Praxis für Batteriebetrieb geeignet ist. Insbesondere ist der Einsatz einer die Zylinderfläche aufweisenden Zylinderlinse mit einer langen Brennweite, wie z.B. im dritten Ausführungsbeispiel der Erfindung gezeigt, für das Pumpen eines Lasers mit einer hohen Energie, insbesondere 1 J oder mehr, vorteilhaft.

Eine erfindungsgemäße Einrichtung hat auch den Vorteil, dass die Positions- und Winkeltoleranzen der Strahlungsquelle, insbesondere in Form eines Laserdioden-Stacks, im Vergleich zum Stand der Technik relativ unkritisch sind. Dadurch kann z.B. die Strahlungsquelle, insbesondere in Form eines Laserdioden-Stacks, als vom Anwender austauschbares Modul vorgesehen sein.

**Legende zu den Hinweisziffern:**

| | | | |
|---|---|---|---|
| 1 | verstärkendes Lasermedium | 19 | Abstrahlwinkel |
| 2 | Eintrittsfläche | 20 | Träger |
| 3 | Austrittsfläche | 21 | Kühlkörper |
| 4 | Laserstrahl | 22, 22'22" | optisches Bauteil |
| 5 | Laserstrahlung | 23 | Zylinderfläche |
| 6 | Seitenfläche | 24 | Eintrittsfläche |
| 7 | Endspiegel | 25 | Austrittsfläche |
| 8 | Auskoppelspiegel | 26 | Träger |
| 9 | Umkehrprisma | 27 | Kühlkörper |
| 10 | Polarisator | 28 | axialer Strahl |
| 11 | Pockels-Zelle | 29 | Zylinderachse |
| 12 | Lamda-Viertel-Plättchen | 30 | Seitenfläche |
| 13 | Strahlungsquelle | 31 | Randstrahl |
| 14 | Optik | 32 | Randstrahl |
| 15 | Barren | 33 | Begrenzungsfläche |
| 16 | Laserdiode | 34 | Begrenzungsfläche |
| 17 | Laserstrahl | 35 | Spiegel |
| 18 | Abstrahlwinkel | 36 | Spiegel |

## Patentansprüche

1. Laser, der ein von einem Festkörper gebildetes verstärkendes Lasermedium (1) und eine Pumpeinrichtung aufweist, von der das verstärkende Lasermedium (1) seitengepumpt ist,
wobei die Pumpeinrichtung eine Strahlungsquelle (13) mit einer Mehrzahl von Laserdioden (16), die Laserstrahlen (17) emittieren, welche parallele, in Richtung einer z-Achse verlaufende Strahlachsen (a) aufweisen und in Richtung einer rechtwinkelig zur z-Achse stehenden x-Achse mindestens doppelt so stark divergieren wie in Richtung einer rechtwinkelig zur z-Achse und rechtwinkelig zur x-Achse stehenden y-Achse, und mindestens ein optisches Bauteil (22, 22', 22") mit zumindest einer Zylinderfläche (23) umfasst, mit der zumindest ein Teil der von den Laserdioden (16) emittierten Laserstrahlen (17) zusammenwirkt und die parallel zur x-Achse liegt und in einer rechtwinkelig zur x-Achse stehenden Ebene gekrümmt ist,
wobei das optische Bauteil (22) eine Eintrittsfläche (24) aufweist, durch welche die von den Laserdioden (16) emittierten Laserstrahlen (17) oder zumindest ein Teil hiervon in das optische Bauteil (22) und durch das optische Bauteil (22) zu einer Austrittsfläche (25) des optischen Bauteils (22) und durch diese zum verstärkenden Lasermedium (1) gelangen oder gelangt, wobei die Eintrittsfläche (24) und die Austrittsfläche (25) von unterschiedlichen Flächen des optischen Bauteils (22) gebildet werden, **dadurch gekennzeichnet, dass** das optische Bauteil (22) eine reflektierend ausgebildete Zylinderfläche (23) aufweist und die von den Laserdioden (16) emittierten Laserstrahlen (17) oder zumindest ein Teil hiervon durch die Eintrittsfläche (24) in das optische Bauteil (22) und durch das optische Bauteil (22) zur reflektierend ausgebildeten Zylinderfläche (23) des optischen Bauteils (22) und von dieser durch das optische Bauteil (22) zur Austrittsfläche (25) des optischen Bauteils (22) und durch diese zum verstärkenden Lasermedium (1) gelangen oder gelangt und dass das optische Bauteil (22) reflektierende Begrenzungsflächen (33, 34) aufweist, die die Ausdehnung der von der Strahlungsquelle (13) emittierten Laserstrahlung in Richtung der x-Achse beidseitig begrenzen.

2. Laser nach Anspruch 1, **dadurch gekennzeichnet, dass** die Strahlungsquelle (13) zwei oder mehr bezogen auf die x-Achse an unterschiedlichen Stellen angeordnete Laserdioden (16) umfasst, deren Laserstrahlen (17) mit der Zylinderfläche (23) zusammenwirken.

3. Laser nach Anspruch 1 oder 2, **dadurch gekennzeichnet, dass** die Strahlungsquelle (13) zwei oder mehr bezogen auf die y-Achse an unterschiedlichen Stellen angeordnete Laserdioden (16) umfasst, deren Laserstrahlen (17) mit der Zylinderfläche (23) zusammenwirken.

4. Laser nach einem der Ansprüche 1 bis 3, **dadurch gekennzeichnet, dass** die Laserstrahlen (17) aller Laserdioden (16) mit der Zylinderfläche (23) des optischen Bauteils (22, 22', 22") zusammenwirken.

5. Laser nach einem der Ansprüche 1 bis 4, **dadurch gekennzeichnet, dass** die Zylinderfläche (23) des Bauteils (22, 22', 22") eine sammelnde Wirkung auf die mit der Zylinderfläche (23) zusammenwirkenden Laserstrahlen (17) hat.

6. Laser nach einem der Ansprüche 1 bis 5, **dadurch gekennzeichnet, dass** die Strahlungsquelle (13) ein Laserdioden-Stack ist, der mehrere Barren (15) mit jeweils mehreren Laserdioden (16) aufweist.

7. Laser nach Anspruch 6, **dadurch gekennzeichnet, dass** die Laserdioden (16) eines Barrens (15) in Richtung der y-Achse beabstandet angeordnet sind.

8. Laser nach Anspruch 7, **dadurch gekennzeichnet, dass** alle Barren (15) oder zumindest ein Teil der Barren (15) bezogen auf die Richtung der x-Achse nebeneinanderliegend angeordnet sind.

## Claims

1. Laser having an amplifying laser medium (1) formed by a solid and having a pumping means by which the amplifying laser medium (1) is side-pumped, the pumping means comprising a radiation source (13) having a plurality of laser diodes (16) which emit laser beams (17) which have parallel beam axes (a) extending in the direction defined by a z axis and which diverge in the direction defined by a x axis lying at right angles to the z axis at least twice as greatly as in the direction defined by a y axis lying at right angles to the z axis and at right angles to the x axis, and comprising at least one optical component (22, 22', 22") having at least one surface in the form of a part-cylinder (23) with which at least some of the laser beams (17) emitted by the laser diodes (16) co-operate and which lies parallel to the x axis and which is curved in a plane lying at right angles to the x axis, the optical component (22) having an entry face (24) through which the laser beams (17) emitted by the laser diodes (16), or at least some thereof, make their way into the optical component (22) and through the optical component (22) to an exit face (25) of the optical component (22) and through this latter to the amplifying laser medium (1), the entry face (24) and exit face (25) being formed by different faces of the optical component (22), **characterised in that** the optical component (22) has a surface in the form of a part-cylinder (23) which is formed to be reflective, and the laser beams (17) emitted by the laser diodes (16), or at least some thereof, make their way through the entry face (24) into the optical component (22) and through the optical component (22) to the surface in the form of a part-cylinder (23) of the optical component (22), which surface is formed to be reflective, and from this latter through the optical component (22) to the exit face (25) of the optical component (22) and through this latter to the amplifying laser medium (1), and **in that** the optical component (22) has reflective boundary surfaces (33, 34) which, on both sides, limit the spread in the direction defined by the x axis of the laser radiation emitted by the radiation source (13).

2. Laser according to claim 1, **characterised in that** the radiation source (13) comprises two or more laser diodes (16) arranged at different points relative to the x axis whose laser beams (17) co-operate with the surface in the form of a part-cylinder (23).

3. Laser according to claim 1 or 2, **characterised in that** the radiation source (13) comprises two or more laser diodes (16) arranged at different points relative to the y axis whose laser beams (17) co-operate with the surface in the form of a part-cylinder (23).

4. Laser according to one of claims 1 to 3, **characterised in that** the laser beams (17) from all the laser diodes (16) co-operate with the surface in the form of a part-cylinder (23) of the optical component (22, 22', 22").

5. Laser according to one of claims 1 to 4, **characterised in that** the surface in the form of a part-cylinder (23) of the component (22, 22', 22") has a condensing effect on the laser beams (17) co-operating with the surface in the form of a part-cylinder (23).

6. Laser according to one of claims 1 to 5, **characterised in that** the radiation source (13) is a laser diode stack which has a plurality of bars (15) each having a plurality of laser diodes (16).

7. Laser according to claim 6, **characterised in that** the laser diodes (16) of a bar (15) are arranged to be spaced apart in the direction defined by the y axis.

8. Laser according to claim 7, **characterised in that** all the bars (15), or at least some of the bars (15), are arranged to be situated next to one another in the direction defined by the x axis.

## Revendications

1. Laser présentant un milieu laser amplificateur (1) formé par un corps solide, et un dispositif de pompage par lequel le milieu laser amplificateur (1) est pompé latéralement, le dispositif de pompage comprenant
- une source de rayonnement (13) avec une pluralité de diodes lasers (16) émettant des faisceaux laser (17) qui présentent des axes de rayonnement (a) parallèles s'étendant en direction d'un axe z et qui divergent en direction d'un axe x perpendiculaire à l'axe z au moins deux fois plus qu'en direction d'un axe y perpendiculaire à l'axe z et perpendiculaire à l'axe x, et
- au moins un composant optique (22, 22', 22") présentant au moins une surface cylindrique (23) avec laquelle interagit au moins une partie des faisceaux laser (17) émis par les diodes laser (16), laquelle surface est parallèle à l'axe x et est cintrée dans un plan formant un angle avec l'axe x,
le composant optique (22) présentant une surface d'entrée (24) traversée par les faisceaux laser (17) émis par les diodes lasers (16), ou au moins une partie de ceux-ci, et qui pénètrent dans le composant optique (22), et qui traversent le composant optique (22) vers une surface de sortie (25) du composant optique (22), et qui traversent celle-ci pour atteindre le milieu laser amplificateur (1), la surface d'entrée (24) et la surface de sortie (25) étant formées par différentes surfaces du composant optique (22), **caractérisé en ce que** le composant optique (22) présente une surface cylindrique (23) conçue réfléchissante et les faisceaux laser (17) émis par les diodes lasers (16), ou au moins une partie de ceux-ci, passent à travers la surface d'entrée (24) et pénètrent dans le composant optique (22), et traversent le composant optique (22) vers la surface cylindrique (23) conçue réfléchissante du composant optique (22) et depuis celle-ci passent à travers le composant optique (22) vers la surface de sortie (25) du composant optique (22) et à travers celle-ci atteignent le milieu laser amplificateur (1), et **en ce que** le composant optique (22) présente des surfaces limites (33, 34) réfléchissantes qui limitent des deux côtés dans la direction de l'axe x l'expansion du rayonnement laser émis par la source de rayonnement (13).

2. Laser selon la revendication 1, **caractérisé en ce que** la source de rayonnement (13) comprend deux ou plusieurs diodes laser (16) disposées en différentes positions par rapport à l'axe x et dont les faisceaux laser (17) interagissent avec la surface cylindrique (23).

3. Laser selon la revendication 1 ou 2, **caractérisé en ce que** la source de rayonnement (13) comprend deux ou plusieurs diodes laser (16) disposées en différentes positions par rapport à l'axe y et dont les faisceaux laser (17) interagissent avec la surface cylindrique (23).

4. Laser selon l'une des revendications 1 à 3, **caractérisé en ce que** les faisceaux laser (17) de toutes les diodes laser (16) interagissent avec la surface cylindrique (23) du composant optique (22, 22', 22").

5. Laser selon l'une des revendications 1 à 4, **caractérisé en ce que** la surface cylindrique (23) du composant (22, 22', 22") présente un effet convergent sur les faisceaux laser (17) coopérant avec la surface cylindrique (23).

6. Laser selon l'une des revendications 1 à 5, **caractérisé en ce que** la source de rayonnement (13) est un empilement de diodes laser qui comprend une pluralité de barres (15) présentant chacune plusieurs diodes laser (16).

7. Laser selon la revendication 6, **caractérisé en ce que** les diodes laser (16) d'une barre (15) sont disposées à distance les unes des autres en direction de l'axe y.

8. Laser selon la revendication 7, **caractérisé en ce que** toutes les barres (15), ou au moins une partie des barres (15), sont disposées côte à côte par rapport à la direction de l'axe x.
